Europäisches Patentamt

European Patent Office

Office européen des brevets

(19)

(11) Numéro de publication : **0 230 810 B1**

(12) # FASCICULE DE BREVET EUROPEEN

(45) Date de publication du fascicule du brevet :
05.06.91 Bulletin 91/23

(51) Int. Cl.⁵ : **H03K 17/04**

(21) Numéro de dépôt : **86402731.3**

(22) Date de dépôt : **09.12.86**

(54) **Circuit de commande rapide de transistors à effet de champ de puissance.**

(30) Priorité : **13.12.85 FR 8518526**

(43) Date de publication de la demande :
**05.08.87 Bulletin 87/32**

(45) Mention de la délivrance du brevet :
**05.06.91 Bulletin 91/23**

(84) Etats contractants désignés :
**AT BE CH DE ES FR GB GR IT LI LU NL SE**

(56) Documents cités :
**EP-A- 0 053 709**
**DE-A- 3 243 660**

(73) Titulaire : **THOMSON-LGT LABORATOIRE
GENERAL DES TELECOMMUNICATIONS
1, rue de l'Hautil
F-78700 Conflans-Sainte Honorine (FR)**

(72) Inventeur : **Nollet, Michel
THOMSON-CSF SCPI 19, avenue de Messine
F-75008 Paris (FR)**

(74) Mandataire : **Lincot, Georges et al
THOMSON-CSF SCPI
F-92045 PARIS LA DEFENSE CEDEX 67 (FR)**

EP 0 230 810 B1

**Description**

Circuit de commande rapide de transistors à effet de champ de puissance

La présente invention concerne un circuit de commande rapide de transistors à effet de champ de puissance.

Elle s'applique à la réalisation des alimentations et convertisseurs à découpage ainsi qu'à celle des dispositifs de commande de moteur à courant continu.

Les transistors de puissance qui sont utilisés dans ces applications doivent pouvoir commuter rapidement pour réduire les pertes d'énergie et augmenter la fréquence de découpage. La réduction des pertes d'énergie permet d'augmenter le rendement, de simplifier les systèmes de refroidissement et d'augmenter la fiabilité. L'augmentation de la fréquence de découpage permet de réduire l'encombrement et le prix des inductances, des transformateurs ainsi que des condensateurs utilisés et augmente la rapidité de réponse des systèmes asservis.

Cependant, l'évolution de ces dispositifs est freinée par deux obstacles principaux qui limitent la rapidité de commutation des transistors à effet de champ, et qui sont les valeurs importantes des capacités d'entrée, grille-source $C_{GS}$ et drain-grille $C_{DG}$, la première ($C_{GS}$) par simple effet capacitif et la seconde par effet Miller. Ces deux capacités, augmentent les temps de montée des signaux de commande appliqués sur les entrées de grilles des transistors à effet de champ et déterminent le temps nécessaire pour passer de la tension $V_{GS(off)}$ pour laquelle le transistor est dans l'état bloqué à la tension $V_{GS(on)}$ pour laquelle il se trouve dans l'état passant.

Pour réduire le temps d'ouverture ou de fermeture d'un transistor à effet de champ de puissance une solution connue consiste à augmenter le courant traversant la grille du transistor. Elle conduit à intercaler un amplificateur de courant à commutation rapide entre le circuit de commande et la grille du transistor de puissance, mais cette solution rencontre quelques difficultés d'adaptation lorsque dans certaines réalisations il faut intercaler une isolation galvanique entre le circuit de commande et la grille. Cette situation se rencontre notamment lorsque, pour une alimentation statique à courant continu, par exemple, la configuration du hâcheur est telle que la source d'un ou plusieurs transistors de puissance est portée à un potentiel important ou variable ou lorsque, pour des considérations de sécurité, il est nécessaire d'isoler le circuit hâcheur du secteur par un photocoupleur ou par un transformateur.

Si un photocoupleur permet la transmission du signal à l'état d'information il a l'inconvénient qu'il doit être suivi d'un amplificateur rapide alimenté par une source d'énergie elle-même galvaniquement isolée, ce qui complique ce type de réalisation.

L'usage d'un transformateur, tel que montré par exemple par la publication de la demande de brevet allemand DE 3243660A, supprime par contre cet inconvénient. Dans ce circuit, des condensateurs sont couplés à l'enroulement secondaire du transformateur. Parallèlement au chargement desdits condensateurs, les grilles des transistors à effet de champ sont soumises aux signaux de commande fournis par le transformateur. Cependant, pour être efficace ce transformateur doit posséder une inductance de fuite réduite pour avoir une réponse compatible avec le temps de commande de quelques nanosecondes des transistors à effet de champ de puissance, ce qui rend onéreux ce type de réalisation.

Le but de l'invention est de pallier les inconvénients précités.

A cet effet, l'invention a pour objet un circuit de commande rapide d'au moins un transistor à effet de champ de puissance comprenant un transformateur à enroulement primaire et secondaire pour transmettre sur les grilles de transistors à effet de champ des signaux de commande ayant alternativement un premier et un deuxième niveau de tension de signes opposés comprenant :

– des moyens de stockage d'énergie couplés au transformateur pour emmagasiner, à l'apparition des signaux de commande l'énergie nécessaire à la commande de la grille du transistor à effet de champ de puissance pendant un premier intervalle de temps durant lequel le signal de commande est à son premier niveau de tension

– des moyens de transmission couplés à l'enroulement secondaire du transformateur et alimentés seulement par les moyens de stockage d'énergie pour transférer l'énergie stockée dans les moyens de stockage d'énergie sur la grille de commande du transistor à effet de champ de puissance seulement pendant un deuxième intervalle de temps durant lequel le signal de commande est à son deuxième niveau de tension et

– des moyens d'isolement couplés entre l'enroulement secondaire et les moyens de stockage d'énergie pour interdire le transfert d'énergie de l'enroulement secondaire vers les moyens de stockage d'énergie ainsi qu'aux moyens de transmission d'énergie pendant le deuxième intervalle de temps durant lequel le signal de commande est à son deuxième niveau de tension.

D'autres caractéristiques et avantages de l'invention apparaîtront à l'aide de la description qui va suivre faite au regard des dessins annexés qui représentent :

– les figures 1 et 2 des courbes illustrant le comportement d'un transistor à effet de champ de puissance à un signal de commande quelconque appliqué sur son électrode de grille ;

– la figure 3 l'organisation connue pour commander un transistor de puissance à effet de champ ;
– la figure 4 une représentation d'un signal de commande ;
– la figure 5 un schéma de réalisation d'un dispositif de commande à transformateur de type "push-pull" de deux transistors à effet de champ de puissance ;
– la figure 6 un exemple de réalisation d'un circuit de commande rapide à transistors à effet de champ de puissance selon l'invention.

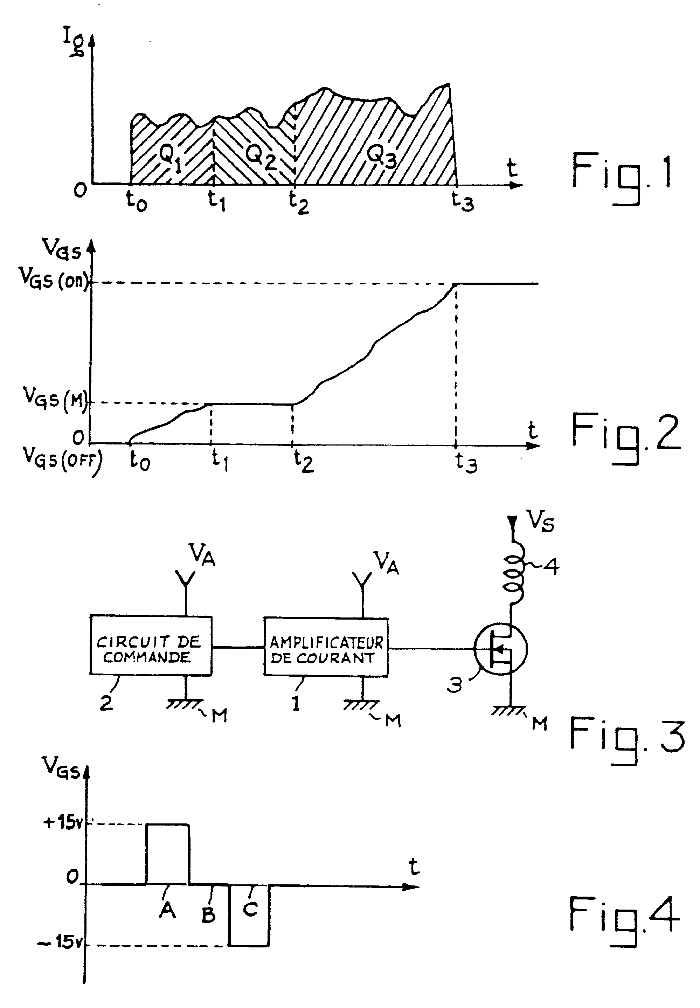

Les courbes représentées aux figures 1 et 2 illustrent l'évolution générale connue de la tension grille-source $V_{GS}$ d'un transistor à effet de champ en fonction du courant grille $I_g$ qui lui est appliqué par son circuit de commande de grille extérieur. Ces courbes résultent du fait que les deux capacités d'entrée, grille-source $C_{GS}$ et drain-grille $C_{DG}$ d'un transistor limitent la dérivée $\dfrac{dV_{GS}}{dt}$ de la tension grille-source $V_{GS}$ par rapport au temps t applicable à la grille par le circuit de commande et déterminent donc le minimum de temps nécessaire pour passer de la tension de grille $V_{GS(off)} = 0$ à la tension de grille $V_{GS(on)}$, et le temps de passage de la tension $V_{GS(on)}$ à la tension $V_{GS(off)}$ (commutation à l'ouverture). Le temps de passage de $V_{GS(off)}$ à $V_{GS(on)}$ est en première approximation égal à la somme des temps de charge de la capacité d'entrée $C_{GS}$ et du temps de décharge de la capacité drain-grille $C_{DG}$. Sur les figures 1 et 2 la capacité grille-source $C_{GS}$ se charge entre les instants $t_o$ et $t_1$ en recevant une quantité d'électricité $Q_1$ puis, entre les instants $t_2$ et $t_3$ en recevant une quantité d'électricité $Q_3$ et la capacité drain-grille se décharge entre les instants $t_1$ et $t_2$ en restituant une quantité d'électricité $Q_2$.

Entre les instants $t_o$ et $t_1$, la totalité du courant de grille $I_g$ passe au travers de la capacité grille-source $C_{GS}$. Au temps $t_1$ la quantité d'électricité $Q_1$ emmagasinée dans la capacité grille-source $C_{GS}$ vérifie l'équation :

$$Q_1 = \int_{t_o}^{t_1} I_g \cdot dt$$

Entre les instants $t_1$ et $t_2$, la tension $V_{GS}$ se stabilise par effet Miller à la valeur $V_{GS(M)}$ la capacité grille-source $C_{GS}$ reçoit un courant nul et la capacité drain-grille $C_{DG}$ reçoit la totalité du courant de grille $I_g$. Au temps $t_2$ la quantité d'électricité qui a traversé la capacité drain-grille $C_{DG}$ vérifie l'équation

$$Q_2 = \int_{t_1}^{t_2} I_g \cdot dt$$

Entre les instants $t_2$ et $t_3$ la totalité du courant de grille $I_g$ s'écoule dans la capacité grille-source $C_{GS}$. Entre $t_2$ et $t_3$, la quantité d'électricité emmagasinée dans la capacité grille-source $C_{GS}$ vérifie l'équation

$$Q_3 = \int_{t_2}^{t_3} I_g \cdot dt.$$

Dans le cas général, la fonction $I_g = f(t)$ étant inconnue, il n'est pas possible de calculer sa primitive $\int I_g \cdot dt$. Mais comme les états initiaux et finaux $t_o$ et $t_3$ sont eux définis et qu'en première approximation le courant $I_g$ peut être considéré comme à peu près constant dans ces intervalles, il est possible de poser

$$\int_{t_o}^{t_1} I_g \cdot dt = \left[\varepsilon_{1g}\right]_{t_o}^{t_1} = I_{1g}(t_1 - t_o)$$

$$\int_{t_1}^{t_2} I_g \cdot dt = \left[\varepsilon_{2g}\right]_{t_1}^{t_2} = I_{2g}(t_2 - t_1)$$

$$\int_{t_2}^{t_3} I_g \cdot dt = \left[\varepsilon_{3g}\right]_{t_2}^{t_3} = I_{3g}(t_3 - t_2)$$

$\varepsilon_1(g)$, $\varepsilon_2(g)$ et $\varepsilon_3(g)$ sont des primitives respectives des fonctions $I_g(t)$ définies sur les intervalles $t_o$ à $t_1$, $t_1$ à $t_2$ et $t_2$ à $t_3$. $I_{1g}$, $I_{2g}$ et $I_{3g}$ sont les courants de grille moyens entre $t_o$ et $t_1$, $t_1$ et $t_2$, $t_2$ et $t_3$. Ces intervalles de temps sont définis par les relations

$$t_1 - t_o = \frac{Q_1}{I_{1g}} = \frac{V_{GS(M)} \cdot C_{GS}}{I_{1g}}$$

$$t_2 - t_1 = \frac{Q_2}{I_{2g}} = \frac{V_{DS(off)} \cdot G_{GD}}{I_{2g}}$$

$$t_3 - t_2 = \frac{Q_3}{I_{3g}} = \frac{V_{GS(on)} - V_{GS(M)} C_{GS}}{I_{3g}}$$

Le temps total de commutation est dans ces conditions égal à

$$tc = t_3 - t_o \text{ et égal à } t_3 - t_2 + t_2 - t_1 + t_1 - t_o$$

soit encore :

$$tc = \frac{V_{GS(M)} \cdot C_{GS}}{I_{1g}} + \frac{V_{DS(off)} C_{GD}}{I_{2g}} + \frac{V_{GS(on)} - V_{GS(M)} C_{GS}}{I_{3g}}$$

L'ensemble de ces relations fait apparaître que les temps nécessaires à l'ouverture ou à la fermeture d'un transistor à effet de champ peuvent être réduits en augmentant la valeur du courant moyen $I_{2g}$.

Mais les dispersions de la tension $V_{GSth}$ qui représente la tension grille-source de seuil, d'une part, et la nécessité d'une rapide immunité au bruit à la fermeture comme à l'ouverture d'autre part, amènent également à augmenter les valeurs des courants moyens $I_1(g)$ et $I_3(g)$.

Ainsi, pour profiter d'un des principaux avantages d'un transistor à effet de champ conféré par sa rapidité, il faut renoncer à l'avantage important procuré par ses facilités de commande en tension. En prenant, par exemple, le cas d'un transistor type IRF350, et en tenant compte du fait que ses capacités grille-source $C_{GS}$ et drain-source $C_{DS}$ ne peuvent pas être considérés comme des constantes pour des tensions $V_{DS}$ comprises entre 0 et 50 volts, la quantité d'électricité à appliquer sur la grille pour obtenir une commutation complète est $Q_1 + Q_2 + Q_3 = Q_c = 120$ nanocoulons. Pour réaliser une commutation dans ces conditions en un temps $(t_3 - t_o)$ 60 nanosecondes, le courant moyen $I_g$ appliqué à la grille doit être égal à

$$I_g = \frac{Q_c}{t_3 - t_o} = \frac{120 \text{ nanocoulons}}{60 \text{ nanosecondes}} = 2 \text{ ampères}$$

Ceci amène, dans les solutions connues, à intercaler des amplificateurs de courant à commutation rapide 1 entre les circuits de commande 2 des transistors de puissance à effet de champ 3 de la façon qui est représentée à la figure 3, alimentés entre un potentiel $V_A$ de tension et un circuit de masse M. Mais ces solutions lorsqu'elles sont mises en oeuvre en réalisant un isolement galvanique à l'aide d'un transformateur, sont coûteuses. D'autre part, les selfs de fuite L des transformateurs doivent être réduites le plus possible pour être compatibles avec les temps de commande de quelques dizaines de nanosecondes des transistors à effet de champ.

La solution proposée par l'invention consiste à intercaler entre chaque transformateur et récepteur de signal à transistor à effet de champ de puissance au moins un élément qui :

    1) demande de l'énergie au transformateur pendant les phases non significatives du signal et emmagasine cette énergie,

    2) reçoit les phases significatives du signal en présentant une impédance infinie sans commander par conséquent d'énergie au transformateur et sans affecter le signal et enfin,

    3) transmet ce signal avec l'énergie nécessaire au récepteur envisagé, cette énergie étant prélevée sur le stock d'énergie réalisé pendant les phases non significatives du signal.

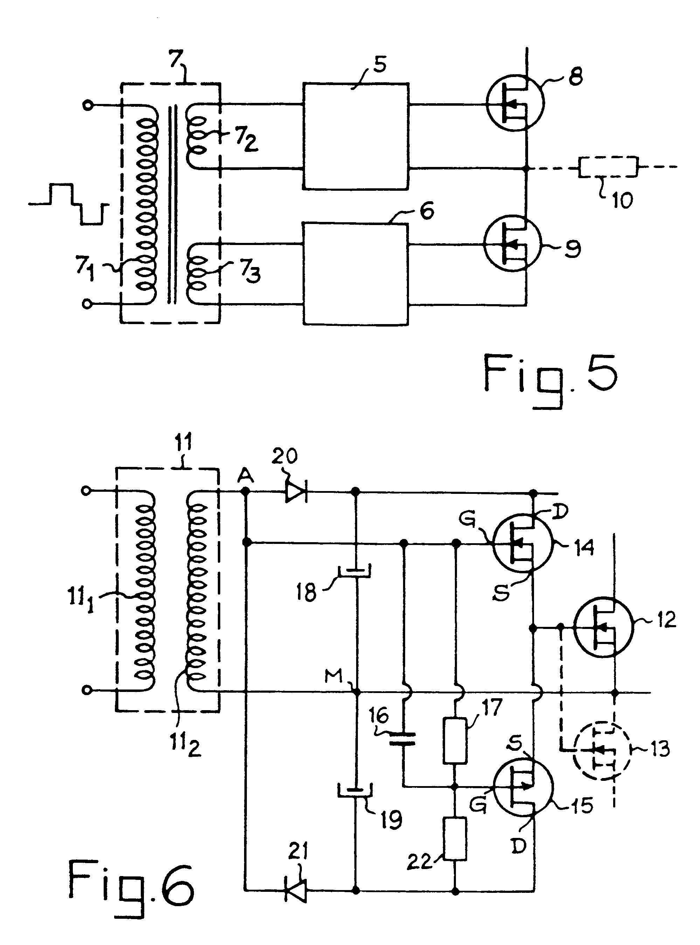

Ce principe peut, non seulement, s'appliquer aux réalisations de commandes de récepteurs de signaux avec des dispositifs selon l'invention intercalés entre un enroulement secondaire d'un transformateur fournissant le signal de commande et chaque dispositif récepteur de signal, mais encore, s'appliquer comme cela est représenté à la figure 5 à plusieurs dispositifs 5, 6, selon l'invention, interposés entre des récepteurs de signaux formés par deux transistors 8, 9 montés en "push-pull" série débitant sur une charge commune 10 représentées en pointillés ; et des enroulements secondaires notés respectivement $7_2$ et $7_3$ de transformateurs 7 dont le primaire $7_1$ est commandé par des signaux de type rectangulaire, de la forme de celui qui est représenté à la figure 4, ayant des alternances positives et négatives durant des intervalles de temps A et C respectivement et une amplitude nulle durant un intervalle de temps B intermédiaire entre les intervalles A et C.

Un exemple de réalisation des circuits 5 et 6 est représenté à la figure 6.

Le circuit selon l'invention qui est représenté à la figure 6 est placé entre un transformateur de signal 11 comportant deux enroulements, primaire et secondaire, notés respectivement $11_1$ et $11_2$, et un récepteur de signal représenté sur la figure 6 par un demi-étage 12 d'un "push-pull" série de puissance, l'autre demi-étage 13 étant en pointillés. Le récepteur de puissance est commandé par deux étages "MOSFET" montés en série 14 et 15 dont les grilles sont reliées respectivement, l'une directement à une borne A de l'enroulement secondaire $11_2$ et l'autre au travers d'un condensateur 16 et d'une résistance 17 montés en parallèle. Les condensateurs 18 et 19 sont montés en parallèle aux bornes du secondaire $11_2$ au travers de deux diodes 20 et 21 reliées respectivement par une anode et une cathode à la borne A pour former avec les condensateurs 18 et 19 un doubleur de tension.

En supposant qu'un signal du type de celui qui est représenté à la figure 4 soit appliqué au primaire $11_1$ du transformateur 11, le fonctionnement du circuit représenté à la figure 6 est le suivant. Ce signal, en apparaissant aux bornes de l'enroulement secondaire $11_2$, charge les condensateurs 18 et 19 pendant les instants marqués A et C sur la figure 4 au travers des diodes 20 et 21 à ses valeurs crêtes, les transistors 14 et 15 étant fermés respectivement pendant les intervalles de temps A et C du signal. Les courants de charge des condensateurs 18 et 19 sont nuls pendant les fronts montants et descendants du signal qui dans ces conditions n'est pas affecté. L'énergie nécessaire au fonctionnement des transistors 14 et 15 qui sont montés en source suiveuse, est ensuite fournie par les condensateurs 18 et 19 qui se trouvent alors isolés du secondaire $11_2$ par les diodes 20 et 21 pendant les phases significatives du signal, les transistors 14 et 15 étant ouverts respectivement pendant les intervalles de temps C et A. De la sorte, aucune énergie n'est prise sur le transformateur pendant les phases significatives du signal. Pour rendre le circuit selon l'invention encore plus efficace, il sera possible de choisir les capacités d'entrée des transistors 14 et 15 de façon qu'elles soient de l'ordre de 100 fois plus faible que celle des transistors de puissance 12 pour résoudre les problèmes de temps de montée et d'amortissement. De même, les valeurs des résistances 17, 22 et du condensateur 16 seront choisies pour polariser efficacement le transistor 15 afin de compenser les tensions de seuil $V_{GSth}$ et à abaisser le palier du signal en-dessous du 0 de tension pour augmenter l'immunité au bruit.

## Revendications

1. Circuit de commande rapide d'au moins un transistor à effet de champ de puissance (12, 13) comprenant un transformateur à enroulement primaire ($11_1$) et secondaire ($11_2$) pour transmettre sur les grilles de transistors à effet de champ des signaux de commande ayant alternativement un premier et un deuxième niveau de tension de signes opposés comprenant :

– des moyens de stockage d'énergie (18, 19) couplés au transformateur (11) pour emmagasiner, à l'apparition des signaux de commande l'énergie nécessaire à la commande de la grille du transistor à effet de champ de puissance (12, 13) pendant un premier intervalle de temps (A, respectivement C) durant lequel le signal de commande est à son premier niveau de tension

– des moyens de transmission (14, 15) couplés à l'enroulement secondaire du transformateur et alimentés seulement par les moyens de stockage d'énergie (18, 19) pour transférer l'énergie stockée dans les moyens de stockage d'énergie (18, 19) sur la grille de commande du transistor à effet de champ de puissance (12, 13) seulement pendant un deuxième intervalle de temps (C, respectivement A) durant lequel le signal de commande est à son deuxième niveau de tension, et

– des moyens d'isolement (20, 21) couplés entre l'enroulement secondaire ($11_2$) et les moyens de stockage d'énergie (18, 19) pour interdire le transfert d'énergie de l'enroulement secondaire ($11_2$) vers les moyens de stockage d'énergie (18, 19) ainsi qu'aux moyens de transmission d'énergie (14, 15) pendant le deuxième intervalle de temps durant lequel le signal de commande est à son deuxième niveau de tension.

2. Circuit selon la revendication 1, caractérisé en ce que les moyens de stockage d'énergie (18, 19) comprennent au moins un condensateur monté en parallèle aux bornes de l'enroulement secondaire ($11_2$) du transformateur au travers d'au moins une diode (20, 21).

3. Circuit de commande selon l'une quelconque des revendications 1 et 2, caractérisé en ce que les moyens de transmission sont constitués par des transistors à effet de champ (14, 15) montés en étage suiveur de tension alimentés par les moyens de stockage (18, 19).

4. Circuit de commande selon la revendication 3, caractérisé en ce que les moyens de transmission (14, 15) sont constitués par un étage de type "push-pull" formé par deux transistors à effet de champ (14, 15) complémentaires montés en série et dont les électrodes de source sont reliées à au moins une grille des transistors à effet de champ (12, 13) de puissance à commander.

## Ansprüche

1. Schnelle Steuerschaltung mit wenigstens einem Leistungsfeldeffekttransistor (12, 13), mit einem Transformator mit Primärwicklung (111) und Sekundärwicklung (112) für die Übertragung von Steuersignalen, die abwechselnd einen ersten und einen zweiten Spannungspegel mit entgegengesetzten Vorzeichen besitzen, an die Gates der Feldeffekttransistoren und mit :

– Energiespeichermitteln (18, 19), die mit dem Transformator (11) verbunden sind, um beim Auftreten der Steuersignale während eines ersten Zeitintervalls (A bzw. C), während dem das Steuersignal auf dem ersten Spannungspegel liegt, die zum Steuern des Gates des Leistungsfeldeffekttransistors (12, 13) erforderliche Energie zu speichern,

– Übertragungsmitteln (14, 15), die mit der Sekundärwicklung des Transformators verbunden sind und ausschließlich durch die Energiespeichermittel (18, 19) versorgt werden, um die in den Energiespeichermitteln (18, 19) gespeicherte Energie ausschließlich während eines zweiten Zeitintervalls (C bzw. A), während dem das Steuersignal auf seinem zweiten Spannungspegel liegt, an das Steuergate des Leistungsfeldeffekttransistors (12, 13) zu übertragen, und

– Isoliermitteln (20, 21), die zwischen die Sekundärwicklung (112) und die Energiespeichermittel (18, 19) geschaltet sind, um während des zweiten Zeitintervalls, während dem das Steuersignal auf seinem zweiten Spannungspegel liegt, die Übertragung der Energie von der Sekundärwicklung (112) sowohl an die Energiespeichermittel (18, 19) als auch an die Energieübertragungsmittel (14, 15) nicht zuzulassen.

2. Schaltung gemäß Anspruch 1, dadurch gekennzeichnet, daß die Energiespeichermittel (18, 19) wenigstens einen Kondensator umfassen, der über wenigstens eine Diode (20, 21) parallel zu den Anschlüssen der Sekundärwicklung (112) des Transformators angeordnet ist.

3. Steuerschaltung gemäß einem der Ansprüche 1 und 2, dadurch gekennzeichnet, daß die Übertragungsmittel von Feldeffekttransistoren (14, 15) gebildet werden, die als Spannungsfolgerstufe angeordnet sind und durch die Speichermittel (18, 19) versorgt werden.

4. Steuerschaltung gemäß Anspruch 3, dadurch gekennzeichnet, daß die Übertragungsmittel (14, 15) durch eine Stufe vom "Push-Pull"-Typ gebildet werden, die aus zwei komplementären, in Reihe geschalteten Feldeffekttransistoren (14, 15) ausgebildet wird, deren Source-Elektroden mit wenigstens einem Gate der zu steuernden Leistungsfeldeffekttransistoren (12, 13) verbunden sind.

## Claims

1. A high speed control circuit for at least one power field effect transistor (12 and 13) comprising a transformer with a primary winding ($11_1$) and a secondary winding ($11_2$) in order to transmit control signals to the gates of the field effect transistors, such control signals having alternatively a first and a second voltage level, such levels being of opposite sign, comprising :

    – energy storing means (18 and 19) coupled with the transformer (11) in order to store, on the appearance of the control signals, the energy necessary for the control of the gate of the power field effect transistor (12 and 13) during a first interval of time (A and, respectively, C) during which the control signal is at its first voltage level,

    – transmission means (14 and 15) coupled with the secondary winding of the transformer and solely supplied by energy storing means (18 and 19) in order to transfer the energy stored in the energy storing means (18) to the control gate of the power field effect transistor (12 and 13) solely during a second interval of time (C and, respectively, A) during which the control signal is at its second voltage level, and

    – isolating means (20 and 21) coupled between the secondary winding ($11_2$) and the energy storing means (18 and 19) in order to preclude the transfer of the secondary winding ($11_2$) energy to the energy storing means (18 and 19) and also to the energy transmitting means (14 and 15) during the second interval of time during which the control signal is at its second voltage level.

2. The circuit as claimed in claim 1, characterized in that the energy storing means (18 and 19) comprise at least one capacitor placed in parallel with the terminals of the secondary winding ($11_2$) of the transformer via at least one diode (20 and 21).

3. The circuit as claimed in claim 1 or claim 2, characterized in that the transmission means are constituted by field effect transistors (14 and 15) arranged in a voltage following stage and fed by the storing means (18 and 19).

4. The circuit as claimed in claim 3, characterized in that the transmission means (14 and 15) are constituted by a push-pull stage constituted by two complementary field effect transistors (14 and 15) placed in series and with their source electrodes connected with at least one gate of the power field effect transistors (12 and 13) to be controlled.

Fig.1

Fig.2

Fig.3

Fig.4

Fig.5

Fig.6